# EUROPÄISCHE PATENTSCHRIFT

(11) **EP 2 448 379 B1**
(45) Veröffentlichungstag und Bekanntmachung des Hinweises auf die Patenterteilung: **17.06.2015**
(21) Anmeldenummer: 11185985.6
(22) Anmeldetag: 20.10.2011
(51) Int. Cl.: H05K 1/18, H05K 1/02

(54) **Leiterplatte mit integriertem RFID-Mikrochip**
Circuit board with integrated RFID microchip
Plaquette dotée d'une micropuce RFID intégrée

(30) Priorität: 28.10.2010 DE 202010014862 U
(43) Veröffentlichungstag der Anmeldung: 02.05.2012
(73) Patentinhaber: Beta LAYOUT GmbH, 65326 Aarbergen (DE)
(72) Erfinder: Hofmann, Arne, 65189 Wiesbaden (DE)
(74) Vertreter: Hofstetter, Schurack & Partner

(56) Entgegenhaltungen:
- EP-A1- 2 141 970
- EP-A2- 1 613 134
- JP-A- H04 271 188
- JP-A- 2007 208 294
- US-A1- 2009 294 534
- US-B2- 6 985 112

## Beschreibung

Die Erfindung behandelt die Frage, wie eine Leiterplatte mit einem RFID-Mikrochip gekoppelt werden kann.

Eine Leiterplatte wird auch als Leiterkarte, Platine oder gedruckte Schaltung (auf Englisch: "printed circuit board") bezeichnet, und sie ist ein Träger für elektronische Bauteile. Eine Leiterplatte umfasst ein elektrisch isolierendes Trägermaterial. An diesem haften leitende Verbindungen, so genannte Leiterbahnen. Die Leiterbahnen werden zumeist aus einer dünnen Schicht Kupfer geätzt.

Die Abkürzung "RFID" steht für "radio-frequency identification", es geht also um das Identifizieren unter Verwendung von hochfrequenten (elektromagnetischen) Wellen. Ein so genannter RFID-Transponder wird an dem zu kennzeichnenden bzw. identifizierenden Gegenstand befestigt. Er enthält eine Kennung. Mithilfe eines Lesegeräts lässt sich diese Kennung auslesen.

Der RFID-Transponder umfasst üblicherweise einen Mikrochip auf einem Träger oder in einem Gehäuse, wobei in dem Mikrochip die Kennung gespeichert ist und der Mikrochip mit einer Antenne gekoppelt ist.

Die RFID-Technologie funktioniert auch, wenn lediglich ein RFID-Mikrochip mit dem zu identifizierenden Gegenstand gekoppelt wird. In diesem Falle kann die elektromagnetische Strahlung jedoch lediglich kapazitiv in den Mikrochip eingekoppelt werden, so dass die Prüfung nur aus relativ kurzem Abstand, z. B. von ca. 3 mm, möglich ist.

Möchte man nun Leiterplatten identifizieren, so bietet sich die Verwendung eines RFID-Mikrochips an. Zu diesem Zweck muss der RFID-Mikrochip mit der Leiterplatte in irgendeiner Weise gekoppelt werden.

Man hat bisher die RFID-Transponder oder RFID-Mikrochips einfach auf die Leiterplatte aufgebracht (z. B. durch Kleben oder Löten). Das musste dann jedoch beim Design der Leiterbahnanordnung berücksichtigt werden, denn für den RFID-Mikrochip muss ausreichend Platz zur Verfügung stehen.

Um zu vermeiden, dass der RFID-Mikrochip zu weit nach oben steht, hat man schon bisher durch Fräsen Teile des Leiterplatten-Trägermaterials abgetragen und eine Art Vertiefung gebildet, in die der RFID-Mikrochip eingebracht werden konnte. Diese Vertiefung wurde ausgehend von der oberen Fläche mit den Leiterbahnen gebildet.

Die EP 2 141 970A1 offenbart eine Anordnung, bei welcher ein RFID-Chip in einer Vertiefung einer Leiterplatte angeordnet ist und mit einer Leiterbahn der Leiterplatte verbunden ist, wobei sich die Vertiefung ausschließlich zu einer Leiterplatten-Oberseite oder -Unterseite öffnet.

Eine alternative Anordnung ist in der EP 1 613 134 A2 offenbart, bei welcher der RFID-Chip in einen rechteckförmigen Ausschnitt eingebracht ist, welcher sich an einer Seitenfläche einer Leiterplatte von der Leiterplattenoberseite bis zur Leiterplattenunterseite durchgehend erstreckt, wobei der RFID-Chip mit einer an der Leiterplatte als Antenne ausgebildeten Leiterbahn elektrisch verbunden ist.

Die US 2009/0294534 A1 offenbart eine Anordnung, bei welcher in einer Chipkarte mit einem Schichtenaufbau ein elektronischer Baustein in einem rechteckförmigen Fenster in einer inneren Schicht eingebracht ist.

Es ist zudem bekannt, einen RFID-Mikrochip in das Leiterplatten-Trägermaterial zu integrieren. Hierbei wird die Leiterplatte laminar, also schichtweise, aufgebaut, und in einer Schicht wird der RFID-Mikrochip angeordnet. Dies hat den Nachteil, dass schon beim Bilden der Leiterplatte die spätere Kennung bekannt sein muss. Der Hersteller des Trägers aus dem Trägermaterial ist aber nicht immer dieselbe Firma oder Person, die später die Leiterbahn aufbringt und dann das Bedürfnis hat, eine Kennung bereitzustellen.

Es ist somit Aufgabe der Erfindung, einen Weg aufzuzeigen, wie die Ankopplung eines RAPID-Mikrochips an eine Leiterplatte verbessert werden kann.

Die Aufgabe wird durch eine Leiterplatte mit den Merkmalen gemäß Patentanspruch 1 gelöst. Vorteilhafte Ausgestaltungen sind in den Unteransprüchen genannt.

Die erfindungsgemäße Leiterplatte umfasst somit ein Trägermaterial, wobei die Leiterplatte auf einer oberen und ggf. einer unteren Fläche Leiterbahnen aufweist. In dem Trägermaterial weist sie ferner eine Ausnehmung auf, welche sich in eine an die Oberfläche angrenzende Seitenfläche hinein öffnet und in die hinein ein RFID-Mikrochip eingebracht ist.

Der RFID-Mikrochip wird somit von der Seite her in die Leiterplatte eingebracht, und nicht mehr von oben her. Die Ausnehmung kann daher noch nachträglich, ohne einen Einfluss auf die Leiterbahn zu haben, bereitgestellt werden, z. B. einfach in das Leiterplatten-Trägermaterial hineingefräst werden. Es kann also zunächst die Leiterplatte vollständig hergestellt werden, ohne dass ein RFID-Mikrochip berücksichtigt werden muss. Der eigentliche Träger aus dem Trägermaterial kann hergestellt werden, ohne dass ein RFID-Mikrochip eingebracht werden muss. Die Leiterbahnen können entworfen werden, ohne dass auf einen später hinzutretenden RFID-Mikrochip Rücksicht genommen werden muss. Der RFID-Mikrochip kann vielmehr zu einem beliebigen Zeitpunkt nachträglich an einer fertigen Leiterplatte bereitgestellt werden.

Die Ausnehmung öffnet sich ausschließlich zu einer Seitenfläche hin. Es muss daher nicht an einer Ecke der Leiterplatte ein Schlitz bereitgestellt werden. Je kleiner die Öffnung der Ausnehmung ist, desto stabiler bleibt die Leiterplatte. Es muss lediglich gewährleistet sein, dass der RFID-Mikrochip in die Ausnehmung einbringbar ist. Das "Sichöffnen" ist hier vorliegend auf die Form der Ausnehmung als solcher in dem Trägermaterial bezogen.

Ungeachtet der Form des Trägermaterials kann aber vorgesehen sein, dass die Ausnehmung von einem von dem Trägermaterial verschiedenen Füllstoff ausgefüllt ist. Somit öffnet sich zwar die Form der Ausnehmung, die Ausnehmung ist als solche aber erfüllt und zum Rand hin abgeschlossen. Als Füllstoff eignet sich insbesondere Epoxydharz, wobei dasselbe Epoxydharz oder ein anderes genommen werden kann, wie ein solches Epoxydharz, das in dem Trägermaterial beinhaltet ist. Bevorzugt umfasst das Trägermaterial FR4-Material, dies sind mit Epoxydharz getränkte Glasfasermatten.

Bevorzugt ist die Ausnehmung Ergebnis eines Fräsens in die Seite, zu der die Seitenfläche gehört, und zwar seitlich in das Trägermaterial hinein. Beispielsweise beim Fräsen mit einer kreisförmigen Scheibe wird die Ausnehmung eine gekrümmte Wandung haben. Auf die Form kommt es jedoch letztlich nicht an, solange der RFID-Mikrochip hineinpasst. Alternativ kann die Ausnehmung Ergebnis einer Laserbearbeitung sein (Lasern in die Seite).

Nachfolgend wird eine bevorzugte Ausführungsform der Erfindung unter Bezug auf die Zeichnung näher beschrieben, in der
- Fig. 1: schematisch eine Leiterplatte und einen RFID-Mikrochip vor dessen Einbringen in die Leiterplatte in perspektivischer Ansicht veranschaulicht, und
- Fig. 2: die Leiterplatte aus Fig. 1 in vergrößerter perspektivischer Teilansicht mit integriertem RFID-Mikrochip zeigt.

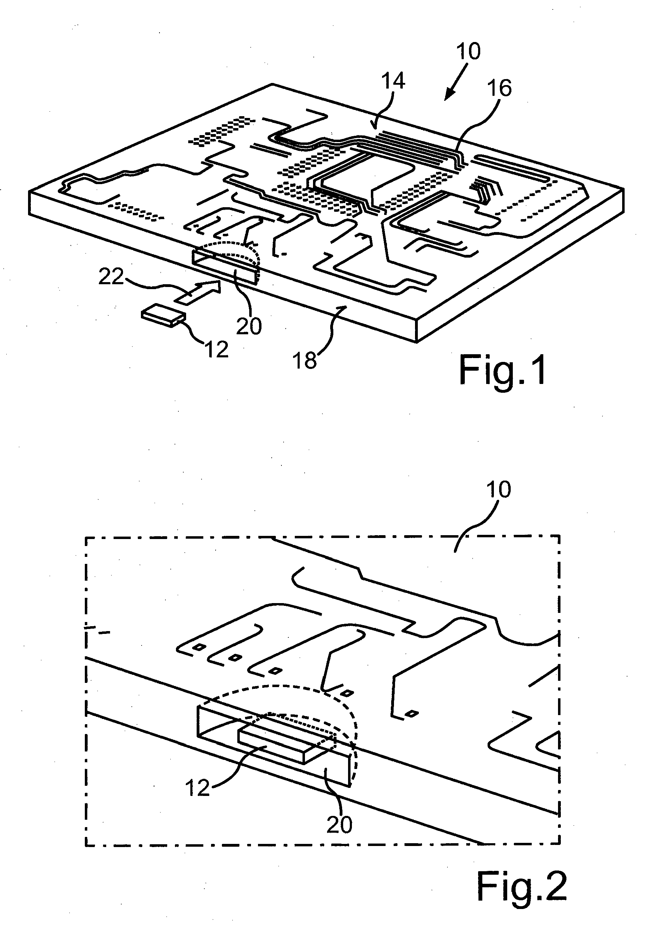

Eine im Ganzen mit 10 bezeichnete Leiterplatte soll mit einem RFID-Mikrochip 12 versehen werden. Die Leiterplatte 10 trägt auf ihrer Oberfläche 14 Leiterbahnen 16, gegebenenfalls auch auf der entgegengesetzten Oberfläche (der Unterseite). Diese Leiterbahnen 16 sollen durch das Vorsehen des RFID-Mikrochips 12 nicht beeinträchtigt werden. Sie sind als bereits vorhanden vorausgesetzt. Man kann nun an einer Seitenfläche 18, die an die Oberfläche 14 angrenzt, mit einem Fräsen einer Ausnehmung 20 beginnen, beispielsweise mithilfe einer kreisrunden Frässcheibe. Führt man diese kreisrunde Frässcheibe im Wesentlichen parallel zur oberen Oberfläche 14 der Leiterplatte 10, dann öffnet sich die Ausnehmung 20 lediglich in die Seitenfläche 18 hinein bzw. ist von dieser her zugänglich; in der Seitenfläche 18 hat sie die Form eines Schlitzes. Somit lässt sich der RFID-Mikrochip 12 bei geeigneter Größe der Ausnehmung 27 gemäß dem Pfeil 22 in die Ausnehmung 20 hinein platzieren. Besteht der Körper der Leiterplatte 10 aus einem Trägermaterial wie beispielsweise FR4-Material (mit Epoxydharz getränkten Glasfasermatten), so lässt sich die Ausnehmung 20 mit Epoxydharz füllen, bei FR4-Material mit demselben Epoxydharz. Das Epoxydharz ist zunächst flüssig und füllt die Ausnehmung 20 aus. Danach lässt man es verhärten. Man erhält so die in Fig. 2 gezeigte Anordnung.

Die Leiterplatte 10 kann mit dem integrierten Mikrochip 12 durch jedermann, der das Fräsen beherrscht, von Hand selbst bereitgestellt werden.

Die Leiterplatte 10 ist nunmehr mithilfe des RFID-Mikrochips 12 identifizierbar. Auf dem RFID-Mikrochip ist eine Kennung abgelegt. Je nach RFID-Typ ist auch eine nachträgliche Programmierung des Mikrochips durch den Anwender möglich.

In den RFID-Mikrochip kann über einen Abstand von 3 mm elektromagnetische Strahlung kapazitiv eingekoppelt werden, so dass die in dem RFID-Mikrochip enthaltene Kennung ausgelesen bzw. geschrieben werden kann. Will man mit größeren Abständen auslesen oder beschreiben, muss eine Antenne für ein Einkoppeln per Funk vorgesehen werden. Entweder kann sogleich ein dem RFID-Transponder mit Antenne und Chip auf einem geeigneten Träger in die Ausnehmung 20 eingebracht werden, oder es bleibt beim Einbringen des Mikrochips 12 alleine in die Ausnehmung 20, und die Antenne wird dann auf der Oberfläche 14 der Leiterplatte 10 angebracht. Hier kann, muss aber nicht immer, eine Anpassung des Verlaufs der Leiterbahnen 16 auf der Oberfläche 14 der Leiterplatte 10 erfolgen.

## Patentansprüche

1. Leiterplatte (10), die ein Leiterplatten-Trägermaterial umfasst und auf einer Oberfläche (14) Leiterbahnen (16) aufweist, wobei die Leiterplatte (10) in dem Leiterplatten-Trägermaterial eine Ausnehmung (20) aufweist, in die ein RFID-Mikrochip (12) eingebracht ist,
**dadurch gekennzeichnet,**
**dass** sich die Ausnehmung (20) ausschließlich zu einer an die Oberfläche (14) angrenzende Seitenfläche (18) hin öffnet.

2. Leiterplatte (10) nach Anspruch 1,
**dadurch gekennzeichnet,**
**dass** die Ausnehmung (20) von einem von dem Leiterplatten-Trägermaterial verschiedenen Füllstoff ausgefüllt ist.

3. Leiterplatte (10) nach Anspruch 2,
**dadurch gekennzeichnet,**
**dass** der Füllstoff Epoxydharz umfasst.

4. Leiterplatte (10) nach einem der vorhergehenden Ansprüche,
**dadurch gekennzeichnet,**
**dass** das Leiterplatten-Trägermaterial FR4-Material umfasst oder ist.

5. Leiterplatte (10) nach einem der vorhergehenden Ansprüche,
**dadurch gekennzeichnet,**
**dass** ein RFID-Transponder mit dem RFID-Mikrochip in die Ausnehmung (20) eingebracht ist.

6. Leiterplatte (10) nach einem der vorhergehenden Ansprüche,
**dadurch gekennzeichnet,**
**dass** die Ausnehmung (20) Ergebnis eines Fräsens oder einer Laserbearbeitung in die Seite der Seitenfläche (18) des Leiterplatten-Trägermaterials hinein ist.

7. Leiterplatte (10) nach einem der vorhergehenden Ansprüche,
**dadurch gekennzeichnet,**
**dass** sie auch auf einer unteren Fläche Leiterbahnen aufweist.

8. Verfahren zur Herstellung einer Leiterplatte (10) mit den Schritten
- Bereitstellen einer Leiterplatte (10), die ein Leiterplatten-Trägermaterial umfasst und auf einer Oberfläche (14) Leiterbahnen (16) aufweist;
- Erzeugen eine Ausnehmung (20) in dem Leiterplatten-Trägermaterial;
- Einbringen eines RFID-Mikrochip (12) in die Ausnehmung (20);
**dadurch gekennzeichnet,**
**dass** die Ausnehmung (20) von einer an die Oberfläche (14) angrenzenden Seitenfläche (18) her erzeugt wird und sich die erzeugte Ausnehmung (20) ausschließlich zu einer an die Oberfläche (14) angrenzenden Seitenfläche (18) hin öffnet.

## Claims

1. A circuit board (10) comprising a circuit board supporting material and having conductive tracks (16) on a surface (14), wherein the circuit board (10) in the circuit board supporting material has a recess (20), into which an RFID microchip (12) is inserted,
**characterized in that**
the recess (20) exclusively opens towards a lateral surface (18), which is adjacent to the surface (14).

2. The circuit board (10) according to claim 1,
**characterized in that**
the recess (20) is filled with a filler different from the circuit board supporting material.

3. The circuit board (10) according to claim 2,
**characterized in that**
the filler comprises epoxy resin.

4. The circuit board (10) according to anyone of the preceding claims,
**characterized in that**
the circuit board supporting material comprises or is FR4 material.

5. The circuit board (10) according to anyone of the preceding claims,
**characterized in that**
an RFID transponder with the RFID microchip is inserted into the recess (20).

6. The circuit board (10) according to anyone of the preceding claims,
**characterized in that**
the recess (20) is the result of milling or laser processing into the side of the lateral surface (18) of the circuit board supporting material.

7. The circuit board (10) according to anyone of the preceding claims,
**characterized in that**
it has conductive tracks also on a bottom surface.

8. A method for manufacturing a circuit board (10) comprising the steps
- providing a circuit board (10), which comprises a circuit board supporting material and on a surface (14) has conductive tracks (16);
- generating a recess (20) in the circuit board supporting material;
- inserting an RFID microchip (12) into the recess (20);
**characterized in that**
the recess (20) is generated from a lateral surface (18), which is adjacent to the surface (14), and **in that** the generated recess (20) opens exclusively towards a lateral surface (18), which is adjacent to the surface (14).

## Revendications

1. Circuit imprimé (10), qui comprend un matériau support de circuit imprimé et présente des pistes conductrices (16) sur une surface (14), moyennant quoi le circuit imprimé (10) présente un évidement (20) dans le matériau support de circuit imprimé, dans lequel une micropuce RFID (12) est introduite,
**caractérisé en ce**
**que** l'évidement (20) s'ouvre exclusivement par rapport à une face latérale (18), adjacente à la surface (14).

2. Circuit imprimé (10) selon la revendication 1,
**caractérisé en ce**
**que** l'évidement (20) est rempli par une matière de remplissage différente du matériau support de circuit imprimé.

3. Circuit imprimé (10) selon la revendication 2,
**caractérisé en ce**
**que** la matière de remplissage est de la résine époxy.

4. Circuit imprimé (10) selon l'une des revendications précédentes,
**caractérisé en ce**
**que** le matériau support de circuit imprimé comprend ou est du matériau FR4.

5. Circuit imprimé (10) selon l'une des revendications précédentes,
**caractérisé en ce**
**qu'**un transpondeur RFID est introduit avec la micropuce RFID dans l'évidement (20).

6. Circuit imprimé (10) selon l'une des revendications précédentes,
**caractérisé en ce**
**que** l'évidement (20) est le résultat d'un fraisage ou d'un traitement au laser dans le côté de la face latérale (18) du matériau support de circuit imprimé.

7. Circuit imprimé (10) selon l'une des revendications précédentes,
**caractérisé en ce**
**qu'**il présente aussi des pistes conductrices sur une face inférieure.

8. Procédé de fabrication d'un circuit imprimé (10) avec les étapes consistant à
- prévoir un circuit imprimé (10), qui comprend un matériau support de circuit imprimé et présente des pistes conductrices (16) sur une surface (14) ;
- créer un évidement (20) dans le matériau support de circuit imprimé ;
- introduire une micropuce RFID (12) dans l'évidement (20) ;
**caractérisé en ce**
**que** l'évidement (20) est créé à partir d'une face latérale (18) adjacente à la surface (14) et que l'évidement (20) créé s'ouvre exclusivement par rapport à une face latérale (18) adjacente à la surface (14).
